# EUROPEAN PATENT APPLICATION

(11) **EP 1 276 014 A1**
(43) Date of publication of application: **15.01.2003**
(21) Application number: 01116952.1
(22) Date of filing: 11.07.2001
(51) Int. Cl.: G03F 7/20, G03F 9/00

(54) **Method of detecting a raised area of a semiconductor wafer**

(71) Applicant: Infineon Technologies AG, 81669 München (DE)
(72) Inventor: Koestler, Wolfram, 01465 Langbrück (DE); Schmidt, Sebastian, 01127 Dresden (DE); Schumacher, Karl, 01099 Dresden (DE)
(74) Representative: Epping Hermann & Fischer

(57) **Abstract**

A method of detecting focus spots (10) during the exposure of semiconductor wafers (1) uses adjacent surface tilt (5) measurements of exposure fields (2) by means of level sensors (5), or focus channels. Adjacent measurements are compared and an error signal is generated in response to a tilt difference exceeding a threshold value. In response to the error signal (50), a data string is generated comprising the wafer identification, the exposure field position and, preferably, a layer currently structured. In a layer-to-layer comparison, a focus spot currently being detected and quickly identified with a possible occurrence of the same wafer and exposure field in a previous layer. A floodlight inspection and rework operation can then be skipped and, alternatively, the occurrence of a new focus spot (10) can be utilised in advanced process control, for e. g. terminating the exposure step of following wafers for investigating the root cause, e. g. contaminating particle problems.

## Description

The present invention relates to a method of detecting a focus spot on a semiconductor wafer in an exposure tool, the semiconductor wafer comprising an array of exposure fields, the exposure tool having a set of level sensors for measuring the tilt of an exposure field surface with respect to the lens projection system.

In semiconductor wafer manufacturing, local surface elevations having a height of a few hundreds of nanometers, but with a diameter of several millimetres, can cause severe problems during the exposure step performed on each of the exposure fields of the semiconductor wafer.

If not corrected by a stage adjustment, these elevations are clearly visible after exposure due to a strong defocus resulting in obliterated structures in the corresponding surface area on the semiconductor wafer. Those features are well known as so-called focus spots, which term is used throughout this document referring to surface elevations of local areas on the semiconductor wafer.

A primary cause for focus spots are contaminating particles residing on the backside surface of the semiconductor wafer, thereby bending the semiconductor wafer if it is locked between a chuck with a plain surface and the wafer backside in, e.g., an exposure tool during exposure. Therefore, a tilt develops on the wafer front side, which eventually cannot be corrected in an adjustment. A possible remedy is to perform a brush or scrubber cleaning of the wafer backside, or alternatively to increase the efforts to increase the quality of those processes, e.g. chemical vapour deposition (CVD), causing the generation of contaminating particles sticking to the wafer backside.

Commonly, the problems are detected only after performing a floodlight or critical dimension measurement using a metrology tool following the exposure of a semiconductor wafer. Thus, in order to guarantee a maximum number of non-damaged integrated circuits, i. e. exposure fields, the semiconductor wafer is sent into rework resulting in a new exposure if a threshold value of one or more exposure fields being affected by focus spots is exceeded.

The current status is that up to 2 % of the exposure step yield is lost due to focus spots. In most fabrication facilities, wafers are combined into lots and focus spot information can only be obtained for this integrated number of wafers. Currently, a typical value of up to 60 % of current memory product lots being affected by focus spots is disadvantageously obtained.

This disadvantageously high yield loss is further increased due to the enhanced semiconductor wafer weight with the advent of the 300 mm wafer technology. As an example, semiconductor wafers are deposited on a set of, e.g., 3 pins during furnace operations, which leave behind so-called boat marks on the wafer backside. The increased weight of the wafer leads to a significant warping at the local pin contact position. This disadvantage cannot easily be corrected in a rework operation since the inherent structure of the wafer is permanently changed.

It is therefore a primary objective of the present invention to increase the yield of wafer manufacturing during the exposure step and to provide a means for detecting the cause of focus spots imposed to semiconductor wafer surfaces.

The objective is solved by a method of detecting a focus spot on a semiconductor wafer in an exposure tool, the semiconductor wafer comprising an array of exposure fields, the exposure tool having a set of level sensors for measuring the tilt of an exposure field surface with respect to the lens projection system, comprising the steps of: providing said semiconductor wafer to said exposure tool, measuring the tilt each of at least a first and a second exposure field using the set of level sensors, comparing the difference of the measured tilt of the at least said first and second exposure field with a threshold value, and issuing an error signal in response to said comparison.

Level sensors, or focus channels, are often provided by exposure tool manufacturers to measure the tilt of an exposure field surface with respect to the projection lens system. The tilt measurement is provided in order to perform a stage adjustment for enabling an optimum focus across the current exposure field. A typical embodiment is to measure the direction of reflected light from the wafer surface originating from, e.g., a laser beam directed each onto the four corners or the centre of the exposure field. The measured data is transferred to a control unit for maintaining the stage adjustment and comprises at least inclination data in x- and y-direction of the local surface.

According to the present invention, adjacent measurements of neighbouring exposure fields should normally provide roughly the same tilt- or levelling-data of the wafer surface. The occurrence of a focus spot, which to an order of magnitude has the same dimension as an exposure field, is expected to deliver a significant deviation from the roughly planar surface. Retrieving and comparing adjacent tilt measurement data therefore advantageously provides information about focus spots occurring across the wafer surface. The present invention therefore provides the means to generate an error signal informing an operator to take actions corresponding to the detection of a focus spot by means of a comparison of the difference of adjacent exposure field tilts with a predefined threshold value that is sufficiently large as compared to typical surface levelling scatter.

Thus, time is saved to detect a focus spot since no floodlight or critical dimension inspection with a metrology tool is necessary to detect focus spots. Moreover, the method is more accurate since it is more objective than inspecting the semiconductor wafer exposure fields by eye in a floodlight inspection.

An important advantage also derives from detecting a possible focus spot, i.e. surface elevation, in the alignment or adjustment step prior to exposure, such that the present method can easily be implemented in advanced process control (APC). The current method can be used to check, whether the currently detected elevation - or focus spot - is due to a previous process thereby already being immanent in a previous exposure step, which is therefore not correctable, or is newly imposed on the current exposure field. In the former case, it is straightforward to decide to proceed with the current exposure since no correction is possible.

In combination with advanced process control, it is also possible to mark the current wafer with a flag sending a signal to the wafer tracking system for specifically being inspected out of a sample of statistically inspected groups.

In a further aspect, a data string is considered to be generated in response to the error signal being issued in response to the comparison of the measured tilt differences and the threshold value. The data string comprises at least the wafer identification number and the exposure field position being affected by said focus spot. Preferably, the data string is stored in a database for being provided to a comparison in a later exposure step. The data string represents an event of a focus spot, which can be used to find the root cause for problems with focus spots. For example, focus spots occurring repeatedly at the same exposure fields of different wafers give a hint by means of their position, thereby pointing to the particular chuck or chamber structure that might be the origin of the, e.g., contaminating particles. The triple pins or specifically structured vacuum channels of CVD-chambers leave behind a specific signature of focus spot positions.

In a further aspect of the present invention, a repeated application of the method steps to different layers of the same exposure fields of the same semiconductor wafer is considered. In particular, if a focus spot is detected before exposing an advanced layer in a given exposure field, the corresponding data string is generated comprising the wafer identification number and the exposure field position. This information can be compared with corresponding data strings, e.g. which are stored in a database, revealing the occurrence of the same focus spot in the same exposure field of the same wafer during the stage adjustment of a previous exposure step, in which a previous layer has been structured. In case that a corresponding entry, i.e. an event, has been found in, e.g., the database, the cause of the focus spot which is currently being detected originates from earlier process steps and therefore the wafer needs not to be reworked.

Alternatively, in case that a corresponding entry is not found, the focus spot is obviously newly imposed to the exposure field, and if a given number of focus spots currently being detected in different exposure fields exceeds a suitable threshold number, the wafer is sent into rework. Since this action is taken without the need of floodlight inspection or any further efforts spent in metrology investigations, time is advantageously saved and costs spent on metrology equipment can be decreased. In the former case, the yield of the exposure step is advantageously increased, since there is no unnecessary rework during this manufacturing step. Hitherto, in many cases tedious protocols had to be written by operators comprising information whether focus spots being detected deviate from former focus spots already evident on the wafer in previous exposure steps, and comprising the decision taken in response to the at least floodlight inspection.

In a further aspect, the case of applying the method to semiconductor wafers with a diameter of at least 300 mm is considered. This case is especially advantageous, since due to the larger wafer weight, the bending or warping of local wafer areas in the vicinity of pin positions on the wafer backside, which hold the wafer on so-called boats in furnace operations, is particularly strong.

Further aspects and advantages are evident from the dependent claims.

The invention will be better understood by reference to embodiments taken in conjunction with the accompanying figures, wherein
figure 1 shows a sideview of a wafer with exposure fields marked on its surface, and having a focus spot due to a particle on the wafer backside,
figure 2 shows a sideview of a wafer with the surface inclinations, or tilts, indicated for each exposure field (a), and the inclinations plotted in a bar chart with a threshold value indicated by a dashed line (b),
figure 3 shows a flowchart of an embodiment according to the present invention with a layer-to-layer characterisation of focus spots in exposure fields.

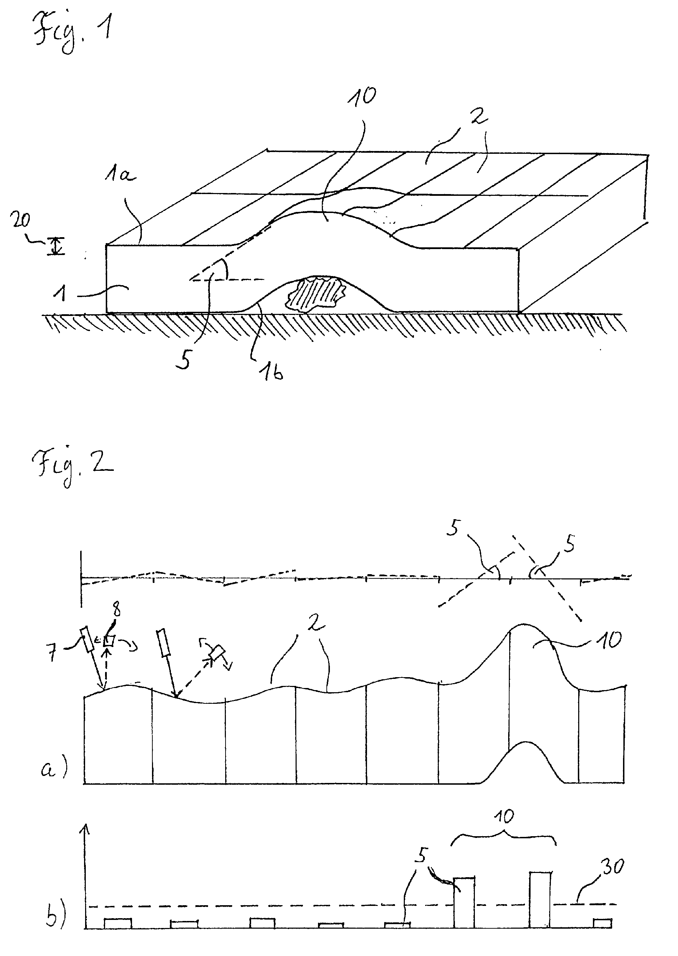

A typical focus spot occurrence originating from a contaminating particle on the backside 1b of a semiconductor wafer 1 is shown in figure 1. If already a first layer has been structured, i.e. exposed, on the wafer frontside 1a, an array of exposure fields 2 is visible on the surface. A focus spot 10 develops due to the bending of the semiconductor wafer 1, and is visible since the top surface level in the focus spot area 10 exceeds a range 20 of admitted exposure focus values valid to structure patterns with specified linewidth tolerances. Therefore, minimum size structures are obliterated in the focus spot area 10 and the corresponding integrated circuit is damaged.

Using a set of typically at least 5 level sensors, also called focus channels, a set of inclination angles 5 representing a surface tilt for each exposure field 2 is measured in order to perform a stage adjustment, as is known in prior art.

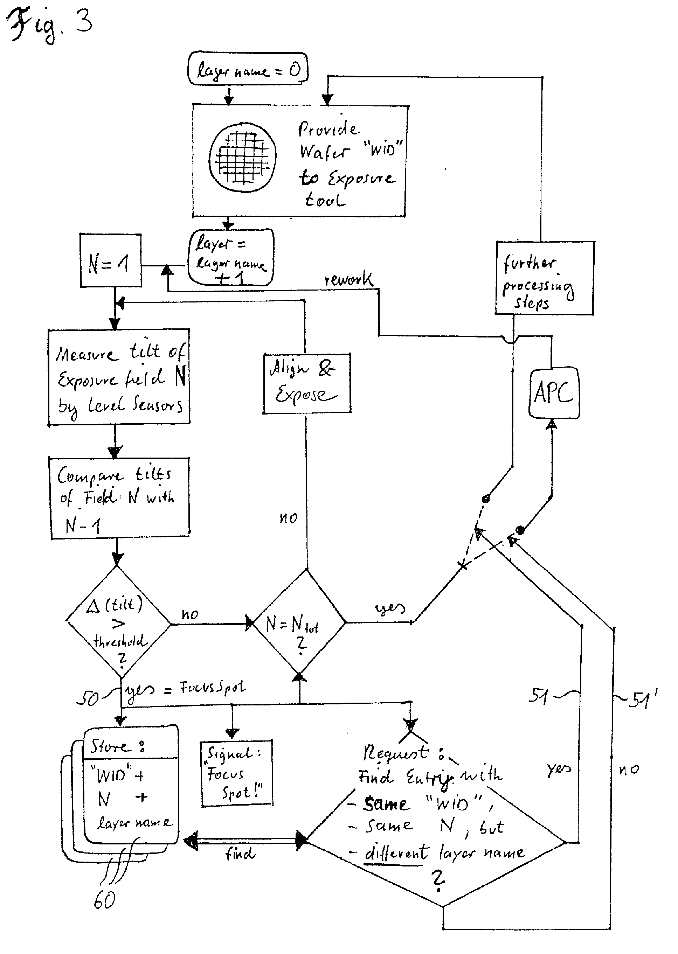

During exposure, surface tilts are measured for each of the adjacent exposure fields as shown in the sideview of figure 2a. There, the surface inclinations are shown on an enlarged scale. Due to local inhomogenities on the wafer surface 1a, a small scatter of surface tilt can be observed. Contrarily, the occurrence of a focus spot 10 leads to strong inclinations, or tilts 5, in its vicinity thereby imposing damage to two integrated circuits embedded in exposure fields 2. The corresponding tilt strengths are shown in a bar chart in figure 2b. According to the method of the present invention, the differences in inclination or tilt values 5 are compared with a threshold value 30 that is previously adapted by testing to provide a reasonable representation of focus spots 10.

An embodiment of the method of the present invention is shown in figure 3. A wafer having the wafer identification number WID is provided to an exposure tool for receiving an exposure of a first layer of its processing sequence comprising a number of layer exposures.

In a loop, each exposure field identified by a number N is measured for its surface tilt 5 by means of a set of level sensors 8, or focus channels, measuring the direction of a laser beam reflected from the surface of an exposure field 2 originating from a laser 7. A measured tilt, which is equivalent to a surface height representation, or is equivalent to a focus value for the exposure tool, is then compared with the corresponding measured tilt 5 of the preceding exposure field 2 having the number N - 1, and the difference is compared with a adapted threshold value as described above.

In case the difference is not significant, the alignment and exposure is continued for each exposure field until the wafer is fully exposed.

But in case the threshold value is exceeded, a focus spot error signal is generated and specified to the operator as a warning message. According to this embodiment, the main issue is that in response to this signal, a data string is generated comprising the wafer identification number WID, the exposure field number N, and the layer name, which is currently being exposed. For example, in the case of memory products, this may be a deep trench layer. In this example, we assume that a focus spot is met at N = 10.

In order to demonstrate the effectiveness of the present embodiment, the description of further post-processing is skipped and the exposure of the second layer of the same wafer having the wafer identification number WID is considered. The same procedure as described above is performed, and at N = 10, a threshold value violation due to large tilt differences repeatedly occurs. Again, a focus spot warning signal is generated as well as the data string comprising the name WID, the exposure field 2 name N = 10 and the current layer, which is considered here to be the gate contact layer. As in the previous case, the data string is stored in a database.

At the same time, a request is started to the database to find an entry of a data string having the same WID name of the wafer 1, the same exposure field name N = 10, but a different layer name, e. g. the deep trench layer. Eventually, the entry is found, thereby indicating the presence of the focus spot in earlier process steps. After completing the exposure, the wafer is therefore directed to further post-processing steps since a rework would not fix the damage of the integrated circuit of exposure field 2 with N = 10.

Now, the case that a second focus spot is detected by the present method at, e.g. N = 20, is considered. No corresponding entry will be found, particularly for the deep trench layer. This event indicates the presence of a new focus spot, and a flag is set urging an operator to investigate the present case. In combination with advanced process control (APC), the following semiconductor wafers 1 of the same lot can be protected from the lithography step if the present focus spot represents a general contaminating particle problem. The present wafer is eventually sent into rework.

### List of reference numerals

- 1: semiconductor wafer
- 1a: wafer frontside
- 1b: wafer backside
- 2: exposure field
- 5: inclination, tilt
- 7: laser
- 8: level sensor, focus channel
- 10: focus spot
- 20: focus range, depth of focus
- 30: threshold value
- 50: error signal
- 50': first error signal
- 50'': second error signal
- 51: signal, previous focus spot found
- 51': signal, previous focus spot not found
- 60: data string

## Claims

1. Method of detecting a focus spot (10) on a semiconductor wafer (1) in an exposure tool, the semiconductor wafer (1) comprising an array of exposure fields (2), the exposure tool having a set of level sensors (8) for measuring the tilt (5) of an exposure field surface with respect to the lens projection system of said exposure tool, comprising the steps of:
a) providing said semiconductor wafer (1) to said exposure tool,
b) measuring the tilt (5) each of at least a first and a second exposure field (2) using the set of level sensors (5),
c) comparing the difference of the measured tilt (5) of said at least first and second exposure field (2) with a threshold value (30),
d) issuing an error signal (50) in response to said comparison.

2. Method according to claim 1,
**characterised by**
generating a data string (60) comprising the identification number (WID) of said semiconductor wafer (1) and the exposure field position (2) in response to said error signal (50).

3. Method according to claim 2,
**characterised in that**
- steps a) - b) are applied to said first and second exposure field (2) of said semiconductor wafer (1), thereby issuing a first error signal (50') for enabling an exposure of a first layer,
- performing said exposure of said first layer of said first and second exposure field (2),
- steps a) - d) are repeated for said first and second exposure field (2) for enabling an exposure of a second layer, thereby issuing a second error signal (50''),
- generating a first and second data string (60) in response to said first and second error signal (50', 50''),
- comparing the first and second data string (60),
- issuing a signal (51, 51') in response to said comparison.

4. Method according to claim 3,
**characterised by**
transmitting said semiconductor wafer (1) to a next manufacturing step without performing an inspection of said first and second exposure field (2) in response to said signal (51) .

5. Method according to claim 3,
**characterised by**
transmitting said semiconductor wafer (1) to a next manufacturing step without performing a rework operation of said semiconductor wafer (1) in response to said signal (51).

6. Method according to any of claims 3 to 5,
**characterised by**
storing said data string (60) generated in response to said error signal (50) in a database.

7. Method according to any of claims 1 to 6,
**characterised in that**
said semiconductor wafer (1) has a diameter of at least 300 mm.

8. Method according to any of claims 1 to 3,
**characterised by**
terminating the exposure step of subsequent semiconductor wafers (1) at the current exposure tool in response to said error signal (50).

9. Method according to claim 3,
**characterised by**
terminating the exposure step of subsequent semiconductor wafers (1) at the current exposure tool in response to said signal (51').
